# EUROPÄISCHE PATENTSCHRIFT

(11) **EP 3 372 910 B1**
(45) Veröffentlichungstag und Bekanntmachung des Hinweises auf die Patenterteilung: **21.10.2020**
(21) Anmeldenummer: 18160225.1
(22) Anmeldetag: 06.03.2018
(51) Int. Cl.: F24F 7/007, F24F 11/52, F24F 11/50, F24F 13/20, H03K 17/96

(54) **LÜFTUNGSGERÄT FÜR EINEN INNENRAUM**
VENTILATING DEVICE FOR AN INTERIOR SPACE
APPAREIL DE VENTILATION POUR UN ESPACE INTÉRIEUR

(30) Priorität: 10.03.2017 DE 102017204049
(43) Veröffentlichungstag der Anmeldung: 12.09.2018
(73) Patentinhaber: MAICO Elektroapparate-Fabrik GmbH, 78056 Villingen-Schwenningen (DE)
(72) Erfinder: Wiedmann, Frank, 78609 Tuningen (DE); Sonntag, Lotar, 78176 Blumberg (DE); Kiefer, Tobias, 78048 Villingen-Schwenningen (DE)
(74) Vertreter: Dietz, Christopher Friedrich

(56) Entgegenhaltungen:
- EP-B1- 0 800 721
- WO-A2-2015/100460
- US-A1- 2015 050 876

## Beschreibung

Die Erfindung betrifft ein Lüftungsgerät für einen Innenraum, wobei das Lüftungsgerät einen Ventilator zum Fördern von Luft, eine Steuereinrichtung zur Ansteuerung des Ventilators sowie eine Bedieneinrichtung zur manuellen Bedienung des Lüftungsgeräts aufweist.

Das Lüftungsgerät dient dem Belüften und/oder Entlüften des Innenraums, insoweit also dem Fördern von Luft in den Innenraum hinein und/oder aus dem Innenraum heraus. Der Innenraum ist beispielsweise als Raum mit erhöhter Feuchtebelastung, insbesondere als Feuchtraum ausgestaltet. Beispielsweise liegt der Innenraum als Badezimmer vor. Zum Belüften beziehungsweise Entlüften des Innenraums verfügt das Lüftungsgerät über den Ventilator, welcher dem Fördern von Luft dient, nämlich insbesondere dem Fördern von Luft in den Innenraum hinein oder aus dem Innenraum heraus, beispielsweise in Abhängigkeit von der Drehrichtung des Ventilators. US2015/0050876 A1 offenbart ein Lüftungsgerät mit den Merkmalen des Oberbegriffs von Anspruch 1.

Der Ventilator wird mithilfe der Steuereinrichtung angesteuert, insbesondere steuernd und/oder regelnd. Beispielsweise verfügt der Ventilator über ein Ventilatorlaufrad sowie über einen Elektromotor zum Antreiben des Ventilatorlaufrads. Der Elektromotor ist insoweit bevorzugt drehfest und/oder permanent mit dem Ventilatorlaufrad gekoppelt, insbesondere unmittelbar. Der Elektromotor kann beispielsweise als elektronisch kommutierter Elektromotor ausgestaltet sein, welcher auch als bürstenloser Gleichstrommotor beziehungsweise als EC-Motor bezeichnet werden kann. Der Ventilator beziehungsweise der Elektromotor wird bevorzugt mittels Pulsweitenmodulation angesteuert. Besonders bevorzugt ist der Ventilator als Radialventilator ausgestaltet. Auch eine andere Ausgestaltung ist jedoch realisierbar, zum Beispiel kann der Ventilator alternativ auch als Axialventilator, Diagonalventilator, Zentrifugalventilator, Tangentialventilator oder Querstromventilator vorliegen.

Grundsätzlich dient die Steuereinrichtung dem Ansteuern des Ventilators beziehungsweise des Elektromotors. Beispielsweise ist die Steuereinrichtung zur Übermittelung von Steuerbefehlen an den Ventilator ausgestaltet, wobei die Steuerbefehle beispielsweise ein Tastverhältnis für eine Pulsweitenmodulation umfassen. Die Steuerbefehle werden bevorzugt von einer Logikeinheit des Ventilators ausgewertet und das Tastverhältnis für die Ansteuerung des Elektromotors, insbesondere für die Pulsweitenmodulation, aus ihnen extrahiert. Nachfolgend steuert die Logikeinheit den Elektromotor entsprechend des Tastverhältnisses an. Bevorzugt umfasst die Logikeinheit einen Wechselrichter, an welchen eine oder mehrere Phasen des Elektromotors angeschlossen sind. Mittels der Logikeinheit wird nun eine an ihr anliegende Versorgungsspannung in Abhängigkeit von dem Tastverhältnis in eine effektive Spannung umgesetzt und an dem Elektromotor beziehungsweise an einer der Phasen des Elektromotors angelegt. Alternativ kann die Steuereinrichtung über den Wechselrichter verfügen, an welchen die eine oder die mehreren Phasen des Elektromotors angeschlossen sind.

Zusätzlich zu der Steuereinrichtung verfügt das Lüftungsgerät über die Bedieneinrichtung. Diese dient der manuellen Bedienung des Lüftungsgeräts. Bekannt ist es beispielsweise, die Bedieneinrichtung in einem Innenraum eines Gehäuses des Lüftungsgeräts anzuordnen und die manuelle Bedienung ausschließlich durch einen Installateur des Lüftungsgeräts vorzusehen. Die Bedieneinrichtung dient insoweit einer Erstparametrisierung des Lüftungsgeräts, insbesondere unmittelbar nach einer Installation des Lüftungsgeräts in dem Innenraum. Die Erstparametrisierung wird vorgenommen, bevor das Gehäuse des Lüftungsgeräts verschlossen wird.

Nach dem Schließen des Gehäuses ist die Bedieneinrichtung aus einer Außenumgebung des Lüftungsgeräts beziehungsweise aus dem Innenraum nicht mehr zugänglich. Für eine Umparametrisierung des Lüftungsgeräts muss insoweit das Gehäuse erneut geöffnet werden. Im Rahmen der Parametrisierung, also beispielsweise der Erstparametrisierung und/oder der Umparametrisierung, kann wenigstens ein Parameter des Lüftungsgeräts eingestellt werden. Ein derartiger Parameter ist beispielsweise eine Einschaltverzögerung, eine Nachlaufverzögerung, eine Intervallzeit oder ein von dem Ventilator zu fördernder Volumenstrom. Im Zuge der Parametrisierung kann nun wenigstens einer dieser Parameter, vorzugsweise jedoch mehrere oder alle der genannten Parameter eingestellt beziehungsweise angepasst werden.

Das Lüftungsgerät ist vorzugsweise permanent mit einer Netzspannung beaufschlagt beziehungsweise permanent an ein Stromnetz angeschlossen. Zusätzlich ist das Lüftungsgerät an wenigstens einen Schalter, beispielsweise einen Lichtschalter oder einen dedizierten Lüftungsschalter, angeschlossen. So kann es beispielsweise vorgesehen sein, dass das Lüftungsgerät bei dem Anschalten einer Beleuchtung in dem Innenraum mittels des Lichtschalters unmittelbar oder nach Ablaufen der Einschaltverzögerung auf einen bestimmten Volumenstrom eingestellt wird. Wird die Beleuchtung mittels des Lichtschalters wieder ausgeschaltet, so wird das Lüftungsgerät unmittelbar oder nach Ablauf der Nachlaufverzögerung abgeschaltet oder auf einen zweiten Volumenstrom eingestellt, wobei der zweite Volumenstrom von dem ersten Volumenstrom verschieden ist, insbesondere niedriger ist. Beispielsweise wird also das Lüftungsgerät permanent zumindest mit dem zweiten Volumenstrom betrieben.

Es ist nun Aufgabe der Erfindung, ein Lüftungsgerät für einen Innenraum vorzuschlagen, welches gegenüber bekannten Lüftungsgeräten Vorteile aufweist, insbesondere komfortabel parametrisierbar und zudem langlebig ist.

Dies wird erfindungsgemäß mit einem Lüftungsgerät mit den Merkmalen des Anspruchs 1 erreicht. Bevorzugte Ausführungsformen sind in den abhängigen Ansprüchen definiert. Dabei ist vorgesehen, dass die Bedieneinrichtung wenigstens ein kapazitives Bedienelement aufweist und die Steuereinrichtung und die Bedieneinrichtung als zumindest teilweise in einer Dichtmasse aufgenommene Einheit auf einer Innenseite einer Gehäusewand eines Gehäuses des Lüftungsgeräts zur berührungslosen Betätigung des Bedienelements durch die Gehäusewand hindurch angeordnet sind.

Wird im Rahmen des Lüftungsgeräts zu dessen Parametrisierung ein manueller Schalter, beispielsweise wenigstens ein DIP-Schalter verwendet, so ist dieser gegenüber Feuchtigkeit äußerst empfindlich oder es müssen aufwendige und kostenintensive Maßnahmen getroffen werden, um den Schalter vor Feuchtigkeitseinfluss zu schützen. Insbesondere besteht also die Gefahr, dass in dem feuchtebelasteten Innenraum die Lebensdauer des Lüftungsgeräts durch Feuchtigkeitseinfluss auf den Schalter negativ beeinflusst wird. Aus diesem Grund soll zur Bedienung des Lüftungsgeräts das kapazitive Bedienelement vorgesehen sein, welches Bestandteil der Bedieneinrichtung ist. Selbstverständlich kann eine beliebige Anzahl an derartigen kapazitiven Bedienelementen realisiert sein, beispielsweise lediglich genau ein kapazitives Bedienelement oder mehrere, also mindestens zwei kapazitive Bedienelemente. Das Bedienelement beziehungsweise die Bedienelemente sind beispielsweise durch Ausbildung wenigstens einer Leiterbahn auf einer Leiterplatte der Bedieneinrichtung realisiert.

Zur Realisierung einer feuchtigkeitsfesten Ausgestaltung des Lüftungsgeräts sind die Bedieneinrichtung und die Steuereinrichtung gemeinsam zumindest teilweise in der Dichtmasse aufgenommen, insbesondere mit der Dichtmasse vergossen oder umspritzt, und liegen insoweit als Einheit vor. Das bedeutet, dass die Bedieneinrichtung und die Steuereinrichtung zwar grundsätzlich separat voneinander ausgestaltet sein können, jedoch in derselben Dichtmasse vorliegen, also gemeinsam in dieser aufgenommen beziehungsweise miteinander vergossen oder umspritzt sind. Dabei sind sie auf der Innenseite der Gehäusewand des Gehäuses angeordnet, nämlich derart, dass das Bedienelement durch die Gehäusewand hindurch manuell bedient werden kann, insbesondere durch den Installateur und/oder einen Benutzer des Lüftungsgeräts. Die Dichtmasse kann zum Beispiel als Gießmasse oder Spritzmasse bezeichnet werden. Als Dichtmasse kommt beispielsweise ein Kunstharz, insbesondere ein Epoxidharz, zum Einsatz.

Beispielsweise ist es vorgesehen, dass zumindest die Bedieneinrichtung oder das Bedienelement der Bedieneinrichtung einerseits an der Gehäusewand, bevorzugt unmittelbar an der Gehäusewand, anliegt und andererseits mit der Dichtmasse beaufschlagt ist. Somit ist zumindest das Bedienelement, bevorzugt jedoch sowohl die Bedieneinrichtung als auch die Steuereinrichtung, zwischen der Gehäusewand und der Dichtmasse eingeschlossen und somit feuchtigkeitsfest angeordnet. Unter dem unmittelbaren Anliegen an der Gehäusewand ist zu verstehen, dass vorzugsweise keine Dichtmasse zwischen der Bedieneinrichtung und der Gehäusewand vorliegt.

Die Dichtmasse greift zum Halten des Bedienelements beziehungsweise der Steuereinrichtung und der Bedieneinrichtung an der Gehäusewand bevorzugt an der Gehäusewand selbst an. Die Steuereinrichtung und die Bedieneinrichtung sind also mittels der Dichtmasse an der Gehäusewand befestigt. Durch das unmittelbare Anliegen des Bedienelements an der Gehäusewand wird eine definierte Position des Bedienelements bezüglich der Gehäusewand realisiert, sodass eine zuverlässige Bedienung gewährleistet ist, nämlich einer Bedienung ausgehend von einer der Innenseite gegenüberliegenden Außenseite der Gehäusewand, die dem Innenraum zugewandt ist. Mittels des kapazitiven Bedienelements kann eine berührungslose oder zumindest nahezu berührungslose Bedienung des Lüftungsgeräts umgesetzt sein. Aufgrund der Ausgestaltung der Bedieneinrichtung und der Steuereinrichtung als zumindest teilweise in der Dichtmasse aufgenommenen Einheit, welche zudem auf der Innenseite der Gehäusewand angeordnet ist, wird bevorzugt ein Lüftungsgerät realisiert, welches mindestens gemäß IPX4, IPX5 oder IPX6 gegen Strahlwasser aus allen Richtung geschützt ist.

Eine weitere bevorzugte Ausgestaltung der Erfindung sieht vor, dass die Steuereinrichtung auf einer Leiterplatte angeordnet ist und elektrische Anschlüsse der Leiterplatte über ein mittels einer elektrischen Verbindung an den Anschlüssen angeschlossenes Kabel mit einem Elektromotor des Ventilators elektrisch verbunden ist, wobei die elektrische Verbindung in der Dichtmasse eingegossen ist. Die Steuereinrichtung beziehungsweise elektrische Bauteile der Steuereinrichtung sind auf der Leiterplatte angeordnet und elektrisch mit dieser verbunden. Die Leiterplatte verfügt über elektrische Anschlüsse, die über das Kabel mit dem Elektromotor des Ventilators elektrisch verbunden sind.

Das Kabel ist über die elektrische Verbindung an der Leiterplatte beziehungsweise deren Anschlüssen elektrisch angeschlossen. Bevorzugt ist die elektrische Verbindung als Steckverbindung ausgestaltet. Beispielsweise ist hierzu auf der Leiterplatte eine Steckeraufnahme, insbesondere eine Buchse oder dergleichen angeordnet, wohingegen an dem Kabel ein Stecker vorliegt. Nach dem Herstellen der Steckverbindung zwischen dem Kabel und der Leiterplatte beziehungsweise den Anschlüssen, insbesondere durch das Einstecken des Steckers in die Buchse, wird die Steckverbindung in der Dichtmasse eingebettet, nämlich derart, dass die Anschlüsse sowie die Steckverbindung vollständig in der Dichtmasse aufgenommen sind. Entsprechend ist die Steckverbindung zuverlässig vor Feuchtigkeitseinflüssen geschützt. Allein das Kabel ragt aus der Dichtmasse heraus und verläuft in Richtung des Ventilators. Es kann jedoch auch vorgesehen sein, dass die elektrische Verbindung selbst wasserfest und entsprechend außerhalb der Dichtmasse angeordnet ist. Die elektrische Verbindung kann grundsätzlich verschieden ausgestaltet sein. Lediglich beispielhaft liegt sie als Steckverbindung vor. Sie kann alternativ zum Beispiel als Lötverbindung realisiert sein.

Eine weitere Ausführungsform der Erfindung sieht vor, dass die Gehäusewand eine Ausnehmung aufweist, in die die Steuereinrichtung und die Bedieneinrichtung in einer definierten Montageposition eingesetzt und in der Dichtmasse angeordnet sind. Die Ausnehmung liegt auf der Innenseite der Gehäusewand vor, also auf der dem Innenraum abgewandten Seite der Gehäusewand. Die Ausnehmung dient nach dem Anordnen der Steuereinrichtung und der Bedieneinrichtung in ihr dem zusätzlichen Aufnehmen der Dichtmasse. Die Ausnehmung weist insoweit bevorzugt in wenigstens einer Dimension größere Abmessungen auf als die Steuereinrichtung und die Bedieneinrichtung beziehungsweise die von diesen gebildete Einheit. Bevorzugt sind die Steuereinrichtung und die Bedieneinrichtung teilweise oder sogar vollständig in der Ausnehmung aufgenommen, also in jeder Dimension.

Insbesondere bei vollständig in der Ausnehmung aufgenommener Steuereinrichtung und Bedieneinrichtung können durch vollständiges Ausfüllen der Ausnehmung mit der Dichtmasse insoweit auch die Steuereinrichtung und die Bedieneinrichtung vollständig mit der Dichtmasse überdeckt werden. Vor dem Vergießen mit der Dichtmasse werden die Steuereinrichtung und die Bedieneinrichtung in der definierten Montageposition in die Ausnehmung eingesetzt. Die Montageposition ist dabei derart gewählt, dass nach der Montage des Lüftungsgeräts die berührungslose Betätigung des Bedienelements durch die Gehäusewand hindurch ohne weiteres und reproduzierbar möglich ist. Beispielsweise wird die Montageposition von wenigstens einem an die Gehäusewand angeordneten Stützelement definiert, an welchem die Steuereinrichtung und/oder die Bedieneinrichtung angelegt werden.

Bevorzugt sind die Steuereinrichtung und/oder die Bedieneinrichtung vor dem Vergießen mit der Dichtmasse kraftschlüssig und/oder formschlüssig mit der Gehäusewand verbunden beziehungsweise an dieser befestigt. Bevorzugt ist hierzu an dem wenigstens einen Stützelement zumindest ein Rastelement ausgebildet. Zusätzlich kann an der Steuereinrichtung und/oder der Bedieneinrichtung ein Rastgegenelement vorliegen, das zum Halten der jeweiligen Einrichtung formschlüssig mit dem Rastelement zusammenwirkt.

Eine Weiterbildung der Erfindung sieht vor, dass die Bedieneinrichtung, insbesondere das Bedienelement, ebenfalls auf der Leiterplatte angeordnet ist. Auch die Bedieneinrichtung beziehungsweise elektrische Bauteile der Bedieneinrichtung, sind also an der Leiterplatte angeordnet beziehungsweise elektrisch mit dieser verbunden und/oder zumindest teilweise auf dieser ausgebildet. Dies gilt insbesondere für das Bedienelement, welches beispielsweise als Leiterbahnanordnung auf der Leiterplatte vorliegt. Auf diese Art und Weise kann eine hochintegrierte Einheit aus Bedieneinrichtung und Steuereinrichtung realisiert werden, welche aufgrund ihrer Einstückigkeit zudem einfach zu montieren ist. Insbesondere werden die Steuereinrichtung und die Bedieneinrichtung gemeinsam und gleichzeitig in die Ausnehmung eingebracht beziehungsweise in dieser angeordnet. Dies ist durch die Ausbildung der Bedieneinrichtung und der Steuereinrichtung auf der gemeinsamen Leiterplatte ohne weiteres einfach möglich.

In einer weiteren Ausgestaltung der Erfindung ist vorgesehen, dass die Gehäusewand als abnehmbarer und/oder austauschbarer Gehäusedeckel ausgestaltet ist. Das Abnehmen beziehungsweise Austauschen ist dabei beschädigungsfrei möglich, der Gehäusedeckel kann also ohne weiteres von weiteren Bereichen des Gehäuses, welche als Gehäuseschale bezeichnet werden können, entfernt und wieder an ihnen angebracht werden. Obwohl also die Bedieneinrichtung beziehungsweise ihr wenigstens eines Bedienelement auf der Außenseite der Gehäusewand und mithin ihrer dem Innenraum zugewandten Seite bedient werden können, soll die Gehäusewand abnehmbar beziehungsweise austauschbar sein. Auf diese Art und Weise können beispielsweise unterschiedliche Ausführungsformen des Lüftungsgeräts realisiert sein.

Besonders bevorzugt weist das Lüftungsgerät in einer ersten Ausführungsform einen Gehäusedeckel ohne Bedieneinrichtung und Steuereinrichtung auf. Der Ventilator des Lüftungsgeräts ist insoweit lediglich an die Netzspannung angeschlossen, insbesondere permanent. Eine Parametrisierung des Lüftungsgeräts ist aufgrund des Fehlens der Steuereinrichtung und der Bedieneinrichtung nicht möglich. Diese Möglichkeit kann jedoch durch das Austauschen der Gehäusewand beziehungsweise des Gehäusedeckels nachgerüstet werden, indem eine Gehäusewand verwendet wird, an welcher die Steuereinrichtung und die Bedieneinrichtung vorgesehen sind. Es kann also vorgesehen sein, dass die Gehäusewand ohne diese Einrichtungen von der Gehäuseschale entfernt und durch die Gehäusewand mit Steuereinrichtung und Bedieneinrichtung ersetzt wird. Nachfolgend wird lediglich das Kabel auf seiner der Steuereinrichtung abgewandten Seite elektrisch mit dem Ventilator beziehungsweise dessen Elektromotor verbunden. Nachfolgend steht die vollständige Funktionalität des Lüftungsgeräts zur Verfügung, insbesondere kann dieses parametrisiert werden.

Eine Weiterbildung der Erfindung sieht vor, dass an der Gehäusewand eine Belüftungsöffnung zum Fördern von Luft mittels des Ventilators ausgebildet ist, wobei die Belüftungsöffnung mittels einer beabstandet von ihr an der Gehäusewand befestigten Abdeckung abgedeckt ist. Durch die Belüftungsöffnung hindurch steht der Ventilator in Strömungsverbindung mit dem Innenraum. Über die Belüftungsöffnung kann insoweit mittels des Ventilators Luft aus dem Innenraum heraus oder in den Innenraum hinein gefördert werden. Zur Verbesserung der Optik des Lüftungsgeräts und/oder zur Luftführung ist die Belüftungsöffnung mit der Abdeckung abgedeckt. Diese ist beabstandet von der Belüftungsöffnung an der Gehäusewand befestigt.

Das bedeutet also, dass die Belüftungsöffnung über einen zwischen der Gehäusewand und der Abdeckung ausgebildeten Strömungskanal mit dem Innenraum in Strömungsverbindung steht. Die Abdeckung ist unmittelbar oder mittelbar an der Gehäusewand befestigt, beispielsweise kraftschlüssig, formschlüssig und/oder stoffschlüssig. Insbesondere ist die Abdeckung auf die Gehäusewand aufsteckbar oder mit ihr verrastbar. Es kann alternativ auch vorgesehen sein, dass die Abdeckung einstückig und/oder materialeinheitlich mit der Gehäusewand ausgebildet ist. Auch eine Befestigung der Abdeckung an der Gehäusewand über einen Ventilatoreinsatz kann vorgesehen sein. Die Abdeckung übergreift zumindest die Belüftungsöffnung, nämlich insbesondere in Draufsicht auf das Lüftungsgerät beziehungsweise die Vorderseite der Gehäusewand gesehen.

Eine weitere Ausführungsform der Erfindung sieht vor, dass die Abdeckung verlagerbar, insbesondere abnehmbar, gelagert ist, und/oder die Gehäusewand vollständig abdeckt, sodass zumindest ein von dem Bedienelement definiertes Bedienfeld auf einer Außenseite die Gehäusewand bei an der Gehäusewand angeordneter Abdeckung verdeckt ist. Das abnehmbare Lagern beziehungsweise Befestigen der Abdeckung an der Gehäusewand beziehungsweise dem Gehäusedeckel erfolgt beispielsweise mittels wenigstens eines Scharniers, und/oder von Kraftschlusselementen und/oder Rastelementen. In jedem Fall ist die Abdeckung jedoch bevorzugt reversibel abnehmbar befestigt, kann also beschädigungsfrei von der Gehäusewand entfernt und wieder an ihr angebracht werden.

Die Abdeckung deckt bevorzugt die Gehäusewand zumindest in Draufsicht gesehen vollständig ab oder übergreift sie sogar in wenigstens einer Richtung, vorzugsweise in zwei aufeinander senkrecht stehenden Richtungen, ragt also in der wenigstens einen Richtung über sie hinaus. Bevorzugt schließt die Abdeckung jedoch in der wenigstens einen Richtung, bevorzugt in zwei senkrecht aufeinander stehenden Richtungen, bündig mit der Gehäusewand ab. Die Abdeckung ist derart ausgestaltet, dass sie zumindest das Bedienfeld abdeckt, wenn sie an der Gehäusewand angeordnet ist. Das Bedienfeld liegt auf der Außenseite der Gehäusewand dort vor, wo auf der Innenseite der Gehäusewand das wenigstens eine Bedienelement vorliegt.

Die berührungslose Betätigung des auf der Innenseite der Gehäusewand angeordneten Bedienelements durch die Gehäusewand hindurch ist insoweit durch Angreifen an dem auf der Außenseite der Gehäusewand ausgebildeten Bedienfeld vorgesehen. Beispielsweise muss der Installateur oder der Benutzer seinen Finger auf das Bedienfeld auflegen, um das Bedienelement anzusprechen beziehungsweise zu betätigen. Ist die Abdeckung an der Gehäusewand befestigt, so ist das Bedienfeld bevorzugt derart verdeckt, dass eine normale Betätigung durch den Installateur oder den Benutzer nicht möglich ist. Insbesondere ist der Abstand zwischen der Abdeckung und der Gehäusewand derart bemessen, dass das Bedienfeld nicht mit einem durchschnittlichen Finger erreicht werden kann.

Eine weitere Ausgestaltung der Erfindung sieht vor, dass das Bedienelement zur Ermittlung eines Vorhandenseins der Abdeckung an der Gehäusewand und/oder zur Ermittlung einer Raumluftfeuchte ausgestaltet ist. Das Bedienelement arbeitet kapazitiv. Durch das Anordnen beziehungsweise Entfernen der Abdeckung an oder von der Gehäusewand ändert sich die Permittivität, welche die Messwerte des Bedienelements beeinflusst. Entsprechend kann das Bedienelement verwendet werden, um einen Status der Abdeckung zu bestimmen, wobei dieser Status beschreibt, ob die Abdeckung an der Gehäusewand angeordnet ist oder von ihr entfernt vorliegt. In Abhängigkeit von dem Status kann beispielsweise der Ventilator angesteuert werden. Insbesondere ist es vorgesehen, den Ventilator zu deaktivieren, falls die Abdeckung von der Gehäusewand entfernt wurde beziehungsweise entfernt von ihr vorliegt.

Zusätzlich oder alternativ kann das Bedienelement zur Ermittlung der Raumluftfeuchte herangezogen werden. In Abhängigkeit von der Luftfeuchtigkeit ändert sich wiederum die Permittivität, die von dem Bedienelement wahrgenommen wird beziehungsweise die die Messwerte des Bedienelements beeinflusst. Entsprechend kann anhand der Messwerte des Bedienelements auf die Raumluftfeuchte geschlossen werden. Besonders bevorzugt wird der Ventilator in Abhängigkeit von der Raumluftfeuchte angesteuert.

Eine weitere bevorzugte Ausgestaltung der Erfindung sieht vor, dass die in der Dichtmasse angeordnete Einheit eine Bewegungssensoreinrichtung und/oder eine Statusanzeigeeinrichtung aufweist. Die Bewegungssensoreinrichtung dient dem Erkennen einer Bewegung in dem Innenraum, insbesondere der Bewegung einer Person. Beispielsweise wird der Ventilator in Abhängigkeit von einem Messwert der Bewegungssensoreinrichtung angesteuert. Die Bewegungssensoreinrichtung kann beispielsweise einen Infrarotsensor und/oder einen Radarsensor aufweisen. Auch andere Ausgestaltungen der Bewegungssensoreinrichtung sind jedoch realisierbar.

Zusätzlich oder alternativ verfügt die Einheit über die Statusanzeigeeinrichtung. Die Statusanzeigeeinrichtung verfügt über wenigstens ein Leuchtmittel und/oder einen Bildschirm, mittels welchem ein Status des Lüftungsgeräts angezeigt werden kann. Beispielsweise wird das Parametrisieren des Lüftungsgeräts mithilfe der Statusanzeigeeinrichtung vorgenommen. Das Leuchtmittel kann als Leuchtdiode oder als Glühbirne ausgestaltet sein. Der Bildschirm ist bevorzugt als Segmentanzeige, Matrixanzeige, beispielsweise LED-Matrixanzeige oder LCDbeziehungsweise OLED-Matrixanzeige, ausgestaltet. Die Statusanzeigeeinrichtung ist zum Beispiel als Filterwechselanzeige ausgebildet oder weist eine solche auf.

Eine bevorzugte weitere Ausführungsform der Erfindung sieht vor, dass die Bewegungssensoreinrichtung wenigstens einen in einer die Gehäusewand vollständig durchgreifenden Durchgriffsausnehmung angeordneten Bewegungssensor aufweist. Vorstehend wurde bereits darauf hingewiesen, dass die Bewegungssensoreinrichtung über den Bewegungssensor verfügt, welcher beispielsweise als Infrarotsensor oder als Radarsensor ausgestaltet ist. Der Bewegungssensor ist in der Durchgriffsausnehmung angeordnet, welche in der Gehäusewand ausgebildet ist. Bevorzugt durchgreift die Durchgriffsausnehmung die jeweilige Wand in Richtung ihrer Längsmittelachse vollständig, durchgreift also sowohl die Innenseite als auch die Außenseite der Gehäusewand. Bevorzugt ragt der Bewegungssensor ausgehend von der Bewegungssensoreinrichtung beziehungsweise der Einheit durch die Durchgriffsausnehmung hindurch, bevorzugt bis auf die Außenseite der Gehäusewand. Selbstverständlich kann es auch vorgesehen sein, dass der Bewegungssensor über die Außenseite der Gehäusewand übersteht und insoweit in den Innenraum hineinragt. In jedem Fall ragt der Bewegungssensor zumindest teilweise aus der Dichtmasse heraus.

Schließlich kann im Rahmen einer weiteren Ausführungsform der Erfindung vorgesehen sein, dass die Statusanzeigeeinrichtung wenigstens ein Leuchtmittel aufweist, das in Überdeckung mit einer auf der Innenseite der Gehäusewand ausgebildeten Vertiefung angeordnet ist oder in diese eingreift. Das Leuchtmittel ist beispielsweise als Leuchtdiode oder als Glühlampe ausgestaltet. Es ist derart angeordnet, dass es in Überdeckung mit der Vertiefung vorliegt, also beispielsweise beabstandet von ihr vorliegt jedoch mit ihr fluchtet, oder sogar in die Vertiefung eingreift.

Die Vertiefung bewirkt eine Verjüngung der Gehäusewand, also einer Verringerung der Wandstärke der Gehäusewand. Dies wiederum bewirkt eine bessere Sichtbarkeit der Leuchtmittel auf der Außenseite der Gehäusewand. Die Leuchtmittel sind insoweit derart angeordnet, dass sie bei einem Betrieb die Gehäusewand oder zumindest den Boden der Vertiefung durchstrahlen und insoweit aus dem Innenraum wahrnehmbar sind, zumindest falls die Abdeckung nicht an der Gehäusewand angeordnet ist.

Die Erfindung wird nachfolgend anhand der in der Zeichnung dargestellten Ausführungsbeispiele näher erläutert, ohne dass eine Beschränkung der Erfindung erfolgt. Dabei zeigt:
- Figur 1: eine schematische Darstellung eines Lüftungsgeräts, nämlich einer Gehäusewand eines Gehäuses des Lüftungsgeräts, in einer ersten Darstellung,
- Figur 2: eine schematische Darstellung der Gehäusewand in einer zweiten Darstellung,
- Figur 3: eine Einheit aus einer Bedieneinrichtung und einer Steuereinrichtung, die gemeinsam auf einer Leiterplatte ausgebildet sind, sowie
- Figur 4: eine schematische Darstellung eines Bereichs der Gehäusewand, an welcher die Einheit angeordnet und mit einer Dichtmasse vergossen ist.

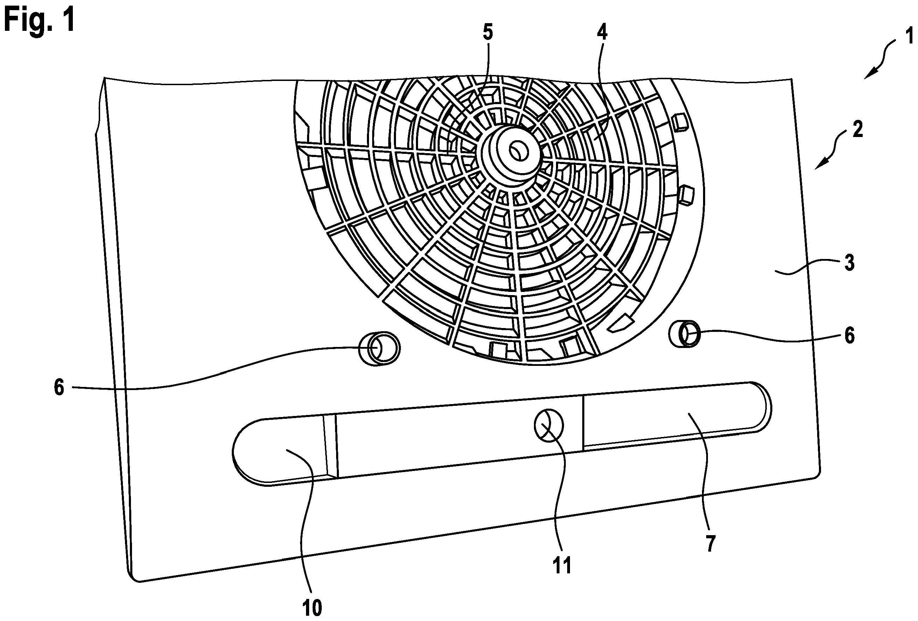

Die Figur 1 zeigt eine erste Darstellung eines Bereichs eines Lüftungsgeräts 1, nämlich einer Gehäusewand 2 eines nicht näher dargestellten Gehäuses des Lüftungsgeräts 1. Gezeigt ist eine Draufsicht auf eine Außenseite 3 der Gehäusewand 2. Es ist erkennbar, dass in der Gehäusewand 2 eine Belüftungsöffnung 4 ausgebildet ist, in welcher ein Strömungsleitgitter 5 angeordnet sein kann. An der Gehäusewand 2 sind Abstandshalter 6 zur definierten Ausrichtung einer hier nicht dargestellten Abdeckung vorgesehen. Beispielsweise dienen die Abstandshalter 6 als Anlageelemente für die Abdeckung beziehungsweise zur Ausrichtung der Abdeckung.

Weiterhin liegt an der Gehäusewand 2 beziehungsweise ihrer Außenseite 3 ein Bedienfeld 7 vor, hinter welchem auf einer der Außenseite 3 abgewandten Innenseite 8 (hier nicht erkennbar) wenigstens ein nicht näher dargestelltes kapazitives Bedienelement einer Bedieneinrichtung 9 des Lüftungsgeräts 1 angeordnet ist. Ein weiteres Bedienfeld 10, welches von dem Bedienfeld 7 abgewandt ist, kann optional vorgesehen sein. Weiterhin kann in der Gehäusewand 2 eine Durchgriffsausnehmung 11 ausgebildet sein, welche die Gehäusewand 2 vollständig durchgreift, jedoch randgeschlossen, also mit durchgehendem Rand, in ihr ausgebildet ist. Die Durchgriffsausnehmung 11 kann zur Aufnahme eines Bewegungssensors 12 (hier nicht dargestellt) einer Bewegungssensoreinrichtung 13 ausgebildet sein.

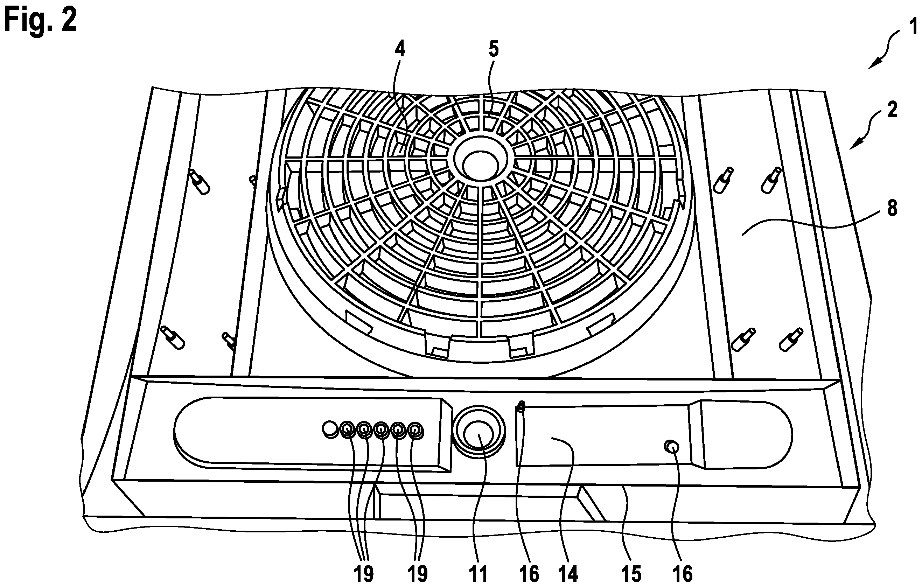

Die Figur 2 zeigt eine Darstellung der Gehäusewand 2 auf der der Außenseite 3 abgewandten Innenseite 8. Erkennbar ist eine Ausnehmung 14, welche vorzugsweise mit einem durchgehenden Rand 15 versehen ist. Von der Ausnehmung 14 geht die Durchgriffsausnehmung 11 aus. Diese erstreckt sich also ausgehend von der Ausnehmung 14 bis hin zu der Außenseite 3 der Gehäusewand 2 beziehungsweise durchgreift diese. In der Ausnehmung 14 sind zwei Stützelemente 16 ausgebildet, welche eine geringere Höhe aufweisen als der Rand 15 und dem Abstützen einer die Bedieneinrichtung 9 sowie eine Steuereinrichtung 17 bildenden Einheit 18 (nicht dargestellt) dienen. Grundsätzlich kann selbstverständlich eine beliebige Anzahl an Stützelementen 16 vorliegen, beispielsweise lediglich ein einziges Stützelement 16 oder mehr als zwei Stützelemente 16.

Weiterhin sind Vertiefungen 19 erkennbar, welche ebenfalls von der Ausnehmung 14 ausgehen und in die Gehäusewand 2 eingreifen. Die Vertiefungen 19 durchgreifen die Gehäusewand 2 in Richtung der Außenseite 3 jedoch lediglich teilweise. Die Vertiefungen 19 sind in Überdeckung mit Leuchtmitteln (nicht dargestellt) angeordnet, welche Bestandteil einer Statusanzeigeeinrichtung des Lüftungsgeräts 1 sind. Die Leuchtmittel können alternativ auch in die Vertiefungen 19 eingreifen.

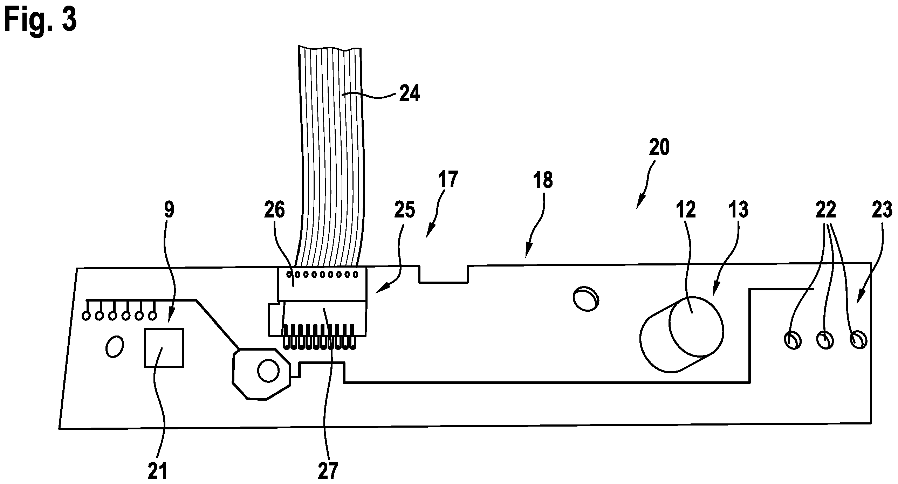

Die Figur 3 zeigt eine Leiterplatte 20, auf welcher die die Bedieneinrichtung 9 und die Steuereinrichtung 17 aufweisende Einheit 18 ausgebildet ist. Erkennbar ist ein kapazitives Bedienelement 21, das auf der Leiterplatte 20 ausgebildet ist und das Bedienfeld 10 definiert. Ebenso sind die Leuchtmittel 22 der Statusanzeigeeinrichtung 23 erkennbar. Zudem ist der Bewegungssensor 12 der Bewegungssensoreinrichtung 13 auf der Leiterplatte 20 angeordnet. Von der Leiterplatte 20 geht ein Kabel 24 aus, das mittels einer Steckverbindung 25 elektrisch mit der Leiterplatte 20 verbunden ist. Beispielsweise weist das Kabel 24 einen Stecker 26 der Steckverbindung 25 und die Leiterplatte 20 eine Steckeraufhahme 27 der Steckverbindung 25 auf. Über das Kabel 24 ist ein nicht dargestellter Elektromotor eines Ventilators des Lüftungsgeräts elektrisch mit der Leiterplatte 20, insbesondere der Steuereinrichtung 17, elektrisch verbunden.

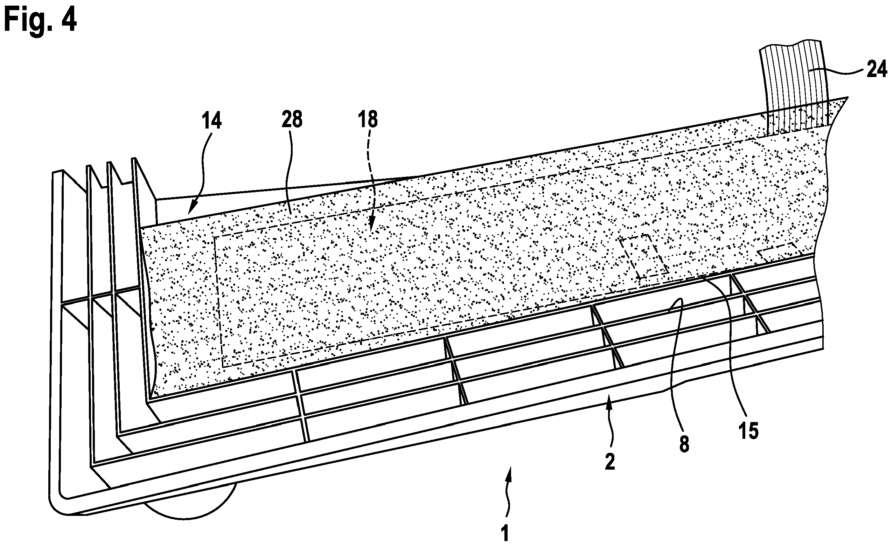

Die Figur 4 zeigt die die Bedieneinrichtung 9 und die Steuereinrichtung 17 aufweisende Einheit 18 in ihrer Einbausituation. Es wird deutlich, dass die Einheit 18 in der Ausnehmung 14 angeordnet und zudem in der Dichtmasse 28 angeordnet ist, insbesondere mit der Dichtmasse 27 vergossen oder umspritzt ist. Die Dichtmasse 28 ist derart aufgebracht, dass sie die Einheit 18, einschließlich der Leiterplatte 20 und der auf dieser angeordneten elektrischen Bauelemente, vorzugsweise vollständig einschließt, mit Ausnahme des Kabels 24, welches aus der Dichtmasse 28 herausragt. Mit einer derartigen Ausgestaltung des Lüftungsgeräts 1 kann eine nahezu vollständige Kapselung der Einheit 18 und insoweit ein hervorragender Schutz vor Feuchtigkeit realisiert sein, sodass das Lüftungsgerät 1 insgesamt bevorzugt die Schutzklasse IPX4, IPX5 oder IPX6 erfüllt.

## Patentansprüche

1. Lüftungsgerät (1) für einen Innenraum, wobei das Lüftungsgerät (1) einen Ventilator zum Fördern von Luft, eine Steuereinrichtung (17) zur Ansteuerung des Ventilators sowie eine Bedieneinrichtung (9) zur manuellen Bedienung des Lüftungsgeräts (1) aufweist und in einer Gehäusewand (2) eines Gehäuses des Lüftungsgeräts (1) eine Belüftungsöffnung (4) zum Fördern von Luft mittels des Ventilators ausgebildet ist, die mittels einer beabstandet von ihr an der Gehäusewand (2) abnehmbar befestigten Abdeckung abgedeckt ist, sodass zumindest ein von dem Bedienelement (21) definiertes Bedienfeld (7) auf einer Außenseite (3) der Gehäusewand (2) bei an der Gehäusewand (2) angeordneter Abdeckung verdeckt ist, **dadurch gekennzeichnet, dass** die Bedieneinrichtung (9) wenigstens ein kapazitives Bedienelement (21) aufweist und die Steuereinrichtung (17) und die Bedieneinrichtung (9) als zumindest teilweise in einer Dichtmasse (28) aufgenommene Einheit (18) auf einer Innenseite (8) der Gehäusewand (2) zur berührungslosen Betätigung des Bedienelements (21) durch die Gehäusewand (2) hindurch angeordnet sind, wobei das Bedienelement (21) zur Ermittlung eines Vorhandenseins der Abdeckung an der Gehäusewand (2) und/oder zur Ermittlung einer Raumluftfeuchte ausgestaltet ist.

2. Lüftungsgerät nach Anspruch 1, **dadurch gekennzeichnet, dass** die Steuereinrichtung (17) auf einer Leiterplatte (20) angeordnet ist und elektrische Anschlüsse der Leiterplatte (20) über ein mittels einer elektrischen Verbindung (25) an den Anschlüssen angeschlossenes Kabel (24) mit einem Elektromotor des Ventilators elektrisch verbunden sind, wobei die elektrische Verbindung (25) in der Dichtmasse (28) eingegossen ist.

3. Lüftungsgerät nach einem der vorhergehenden Ansprüche, **dadurch gekennzeichnet, dass** die Gehäusewand (2) eine Ausnehmung (14) aufweist, in die die Steuereinrichtung (17) und die Bedieneinrichtung (9) in einer definierten Montageposition eingesetzt und in der Dichtmasse (28) angeordnet sind.

4. Lüftungsgerät nach Anspruch 2 oder nach den Ansprüchen 2 und 3, **dadurch gekennzeichnet, dass** die Bedieneinrichtung (9), insbesondere das Bedienelement (21), ebenfalls auf der Leiterplatte (20) angeordnet ist.

5. Lüftungsgerät nach einem der vorhergehenden Ansprüche, **dadurch gekennzeichnet, dass** die Abdeckung die Gehäusewand (2) vollständig abdeckt.

6. Lüftungsgerät nach einem der vorhergehenden Ansprüche, **dadurch gekennzeichnet, dass** die in der Dichtmasse (28) angeordnete Einheit (18) eine Bewegungssensoreinrichtung (13) und/oder eine Statusanzeigeeinrichtung (23) aufweist.

7. Lüftungsgerät nach Anspruch 6, **dadurch gekennzeichnet, dass** die Bewegungssensoreinrichtung (13) wenigstens einen in einer die Gehäusewand (2) vollständig durchgreifenden Durchgriffsausnehmung (11) angeordneten Bewegungssensor (12) aufweist.

8. Lüftungsgerät nach Anspruch 6 oder 7, **dadurch gekennzeichnet, dass** die Statusanzeigeeinrichtung (23) wenigstens ein Leuchtmittel (22) aufweist, das in Überdeckung mit einer auf der Innenseite (8) der Gehäusewand (2) ausgebildeten Vertiefung (19) angeordnet ist oder in diese eingreift.

## Claims

1. A ventilation device (1) for an interior room, the ventilation device (1) having a ventilator for conveying air, a controlling device (17) for driving the ventilator and an operating device (9) for manual operation of the ventilation device (1), and a venting opening (4) being formed in a housing wall (2) of a housing of the ventilation device (1) for conveying air by means of the ventilator, the opening being covered by a lid that is spaced apart from it and removably fixed on the housing wall (2), so that at least an operating panel (7) defined by the operating element (21) on an outer side (3) of the housing wall (2) is hidden from sight when the lid is arranged on the housing wall (2), **characterised in that** the operating device (9) has at least one capacitive operating element (21) and the controlling device (17) and the operating device (9) are arranged as a unit (18) at least partially received in a sealing mass (28) on an inner side (8) of the housing wall (2) for contact-less operation of the operating element (21) through the housing wall (2), wherein the operating element (21) is configured for detecting the presence of the lid on the housing wall (2) and/or for detecting a room air humidity.

2. The ventilation device according to claim 1, **characterised in that** the controlling device (17) is arranged on a circuit board (20) and electrical terminals of the circuit board (20) are electrically connected to an electric motor of the ventilator via a cable (24) connected to the terminals by means of an electrical connection (25), wherein the electrical connection (25) is potted in the sealing mass (28).

3. The ventilation device according to any one of the preceding claims, **characterised in that** the housing wall (2) has a recess (14) into which the controlling device (17) and the operating device (9) are inserted in a defined mounting position and arranged in the sealing mass (28).

4. The ventilation device according to claim 2 or according to claims 2 and 3, **characterised in that** the operating device (9), in particular the operating element (21), is also arranged on the circuit board (20).

5. The ventilation device according to any one of the preceding claims, **characterised in that** the lid completely covers the housing wall (2).

6. The ventilation device according to any one of the preceding claims, **characterised in that** the unit (18) arranged in the sealing mass (28) has a motion sensor device (13) and/or a status display device (23).

7. The ventilation device according to claim 6, **characterised in that** the motion sensor device (13) has at least one motion sensor (12) arranged in a reach-through recess (11) fully penetrating the housing wall (2).

8. The ventilation device according to claim 6 or 7, **characterised in that** the status display device (23) has at least one light source (22) that is arranged so as to overlap a depression (19) formed on the inner side (8) of the housing wall (2) or engages therewith.

## Revendications

1. Appareil de ventilation (1) pour un espace intérieur, l'appareil de ventilation (1) ayant un ventilateur pour le convoyage de l'air, un dispositif de commande (17) pour commander le ventilateur et un dispositif d'exploitation (9) pour l'exploitation manuelle de l'appareil de ventilation (1), et dans lequel une ouverture de ventilation (4) pour le convoyage de l'air au moyen du ventilateur est formée dans une paroi de boîtier (2) d'un boîtier de l'appareil de ventilation (1), l'ouverture étant recouverte par un recouvrement fixé de manière amovible sur la paroi de boîtier (2) à une distance de l'ouverture, de telle manière qu'au moins un panneau de commande (7) défini par l'élément de commande (21) sur un côté extérieur (3) de la paroi de boîtier (2) est couvert lorsque le recouvrement est arrangé sur la paroi de boîtier (2), **caractérisé en ce que** le dispositif d'exploitation (9) a au moins un élément de commande (21) capacitif, et le dispositif de commande (17) et le dispositif d'exploitation (9) sont arrangés à travers la paroi de boîtier (2), sous forme d'une unité (18) reçue d'au moins partiellement dans une masse d'étanchéité (28) sur un côté intérieur (8) de la paroi de boîtier (2), pour l'actionnement sans contact de l'élément de commande (21), dans lequel l'élément de commande (21) est configuré pour détecter la présence du recouvrement sur la paroi de boîtier (2) et/ou pour détecter l'humidité de l'air ambiant dans une pièce.

2. Appareil de ventilation selon la revendication 1, **caractérisé en ce que** le dispositif de commande (17) est arrangé sur une carte à circuit imprimé (20), et les terminaux électriques de la carte à circuit imprimé (20) sont électriquement reliés, par un câble (24) relié aux terminaux au moyen d'une liaison électrique (25), avec un moteur électrique du ventilateur, la liaison électrique (25) étant coulée avec la masse d'étanchéité (28).

3. Appareil de ventilation selon l'une quelconque des revendications précédentes, **caractérisé en ce que** la paroi de boîtier (2) présente une encoche (14), dans laquelle le dispositif de commande (17) et le dispositif d'exploitation (9) sont insérés dans une position de montage définie et arrangés dans la masse d'étanchéité (28).

4. Appareil de ventilation selon la revendication 2 ou selon les revendications 2 et 3, **caractérisé en ce que** le dispositif d'exploitation (9), notamment l'élément de commande (21), est aussi arrangé sur la carte à circuit imprimé (20).

5. Appareil de ventilation selon l'une quelconque des revendications précédentes, **caractérisé en ce que** le recouvrement complètement recouvre la paroi de boîtier (2).

6. Appareil de ventilation selon l'une quelconque des revendications précédentes, **caractérisé en ce que** l'unité (18) arrangée dans la masse d'étanchéité (28) présente un dispositif capteur de mouvement (13) et/ou un dispositif indicateur d'état (23).

7. Appareil de ventilation selon la revendication 6, **caractérisé en ce que** le dispositif capteur de mouvement (13) a d'au moins un capteur de mouvement (12) arrangé dans une encoche de passage (11) complètement pénétrant la paroi de boîtier (2).

8. Appareil de ventilation selon la revendication 6 ou 7, **caractérisé en ce que** le dispositif indicateur d'état (23) a au moins une source lumineuse (22) qui est arrangée en recouvrant une dépression (19) formée sur le côté intérieur (8) de la paroi de boîtier (2), ou est en prise avec celle-ci.
